# FASCICULE DE BREVET EUROPEEN

(11) **EP 4 102 659 B1**
(45) Date de publication et mention de la délivrance du brevet: **30.07.2025**
(21) Numéro de dépôt: 22177541.4
(22) Date de dépôt: 07.06.2022
(51) Int. Cl.: H02B 1/052, H05K 7/12

(54) **DISPOSITIF POUR LA CONNEXION D'UN RAIL À UNE PAROI DE MONTAGE D'UN COFFRET D'UN TABLEAU ÉLECTRIQUE, ET TABLEAU ÉLECTRIQUE COMPRENANT UN TEL DISPOSITIF**
VORRICHTUNG ZUR VERBINDUNG EINER SCHIENE MIT EINER MONTAGEWAND FÜR EINEN KASTEN EINER ELEKTRISCHEN SCHALTANLAGE UND ELEKTRISCHE SCHALTANLAGE MIT EINER SOLCHEN VORRICHTUNG
DEVICE FOR CONNECTING A RAIL TO A WALL OF A MOUNTING A BOX OF AN ELECTRICAL SWITCHBOARD, AND ELECTRICAL SWITCHBOARD COMPRISING SUCH A DEVICE

(30) Priorité: 08.06.2021 FR 2106048
(43) Date de publication de la demande: 14.12.2022
(73) Titulaire: Schneider Electric Industries SAS, 92500 Rueil-Malmaison (FR)
(72) Inventeur: BERTOUL, Ouajdi, 38100 GRENOBLE (FR); BLOCHOUSE, Philippe, 73290 LA MOTTE SERVOLEX (FR); OURY, Christian, 73800 PORTE-DE-SAVOIE (FR)
(74) Mandataire: Lavoix

(56) Documents cités:
- EP-A2- 0 794 602
- EP-B1- 0 762 585
- DE-A1- 102012 102 170
- DE-A1- 102016 201 425
- DE-A1- 102019 105 077
- DE-A1- 102019 126 620
- DE-A1- 2 717 216
- US-A- 3 986 780

## Description

La présente invention concerne un dispositif pour la connexion d'un rail à une paroi de montage d'un coffret d'un tableau électrique et à un tableau électrique comprenant un tel dispositif.

Dans le domaine de la distribution d'énergie électrique, notamment pour des applications de basse tension, il est bien connu d'utiliser des tableaux ou panneaux électriques.

Ces tableaux électriques peuvent avoir des dimensions et configurations variables et comportent un coffret destiné à accueillir divers appareils électriques ou électroniques tels que des disjoncteurs, des relais, des systèmes de câblage, et cetera.

En particulier, l'installation de ces appareils est réalisée en utilisant deux rails métalliques qui sont disposés de manière parallèle entre eux et sont couplés mécaniquement à la paroi postérieure du coffret.

Ensuite, une ou plusieurs guide(s) de montage, telles que de guides du type DIN, sont couplées mécaniquement à leurs extrémités aux deux rails métalliques de façon à former une ou plusieurs rangée(s) de montage pour les appareils et composants à installer.

Actuellement, la connexion des rails métalliques à la paroi postérieure du coffret est réalisée normalement en utilisant un dispositif de connexion ayant un corps réalisé en matériau électriquement isolant à l'intérieur duquel sont incorporés un premier insert métallique fileté, accessible par l'avant, et un deuxième insert métallique fileté accessible par l'arrière.

Pour réaliser l'assemblage, chaque rail métallique est couplé mécaniquement à chaque dispositif de connexion utilisé au moyen d'une vis vissée dans l'insert métallique accessible par l'avant ; ensuite, le produit sous assemblage doit être tourné pour accéder à la partie postérieure et visser une deuxième vis dans le deuxième insert métallique postérieure afin de connecter mécaniquement les rails à la paroi postérieure du coffret.

Cette solution n'est pas totalement satisfaisante, en particulier pour ce qui concerne la méthode de montage puisque la nécessité de tourner un coffret en cours d'assemblage pour accéder à sa partie postérieure induit des difficultés, spécialement quand les coffrets sont lourds. En outre, les temps d'exécution ne sont pas optimisés. Le document DE 2717216 A1 divulgue un dispositif pour la connexion d'un rail en forme de C à une barre conductrice pourvue d'une fente, selon le préambule de la revendication 1.

Le document EP 0794602 A2 divulgue un dispositif pour la connexion d'un rail métallique à une paroi de montage métallique d'un coffret d'un tableau électrique. Le dispositif comporte un corps électriquement isolant ayant une partie centrale qui comporte une surface antérieure pour recevoir une vis de fixation du rail au corps isolant du dispositif, deux bras latérales ayant chacun une surface antérieure, et une partie de fond comportant au moins une surface d'appui, opposée à la surface antérieure, qui est destinée à s'appuyer contre une surface antérieure de la paroi de montage.

Le document DE 102012102170 A1 divulgue un dispositif de montage d'un rail métallique, qui comporte un corps électriquement isolant ayant des éléments d'encliquetage pour encliqueter chacun une portion correspondante du rail, deux parois latérales ayant chacune une surface antérieure d'appui pour une portion correspondante du rail, et une partie de fond comportant une surface d'appui destinée à s'appuyer contre une surface antérieure d'une plaque de montage métallique positionnée à l'intérieure d'un coffret d'un tableau électrique.

Le document DE 102019105077 A1 divulgue un dispositif adaptateur pour la fixation d'un rail de support à une paroi d'une armoire électrique, qui comporte un corps électriquement isolant ayant des pattes de verrouillage qui s'engagent dans des ouvertures du rail, deux parois latérales ayant chacune une surface antérieure d'appui pour une portion correspondante du rail, et une paroi de fond comportant une surface d'appui destinée à s'appuyer contre une surface antérieure de la paroi de montage.

Le document DE 10 2016 201 425 A1 divulgue un dispositif de fixation d'un rail de support à une paroi d'une coffret d'un tableau électrique. Le dispositif comporte un corps électriquement isolant ayant deux bras latéraux qui comportent des crochets d'encliquetage avec le rail, une partie centrale formant une surface d'appui pour une portion correspondante du rail, et une portion de fond comportant une surface d'appui destinée à s'appuyer contre une surface antérieure de la paroi de montage du coffret.

Le document DE 102019126620 A1 divulgue un moyen de fixation pour la fixation de pièces rapportées sur des éléments porteurs, qui comporte une tige ayant une extrémité d'embrochage et une extrémité d'entraînement. La tige forme une paroi latérale qui comporte des éléments d'accrochage élastique. Un dispositif de butée est agencé sur la paroi latérale, à distance axiale d'une surface d'accrochage des éléments. Un élément de support est prévu axialement en direction de l'extrémité d'entraînement, et comporte une surface libre côté embrochage et une surface axiale de blocage côté entraînement. L'extrémité d'entraînement comporte deux bras de verrouillage et un entraînement en saillie axiale.

Le document US 3,986,780 A divulgue un dispositif de fixation destiné à être monté sur un support. Le dispositif de fixation comporte une pièce de support placée à l'extrémité d'une tige, et une plaquette élastique circulaire. La distance séparant les faces opposées planes de la pièce de support et de la plaquette circulaire est égale à l'épaisseur du support. La plaquette circulaire est munie sur sa face interne de deux bossages rectilignes parallèles et dont la longueur est égale à celle d'un des côtés du contour rectangulaire d'une orifice du support.

Le document EP0762585 B1 divulgue un dispositif de fixation avec différentes positions de montage du rail, intégrant des moyens de fixation par encliquetage et par vissage pour sa connexion aux différents éléments de support.

Par conséquent, un but principal de la présente invention est de fournir une solution offrant des améliorations par rapport à l'état de l'art connu, et en particulier de simplifier et accélérer la connexion des rails à la paroi postérieure d'un coffret, en assurant en même temps le maintien de l'indice ou dégrée de protection électrique prévu pour ces dispositifs.

Ce but est atteint par un dispositif pour la connexion d'un rail métallique à une paroi de montage métallique d'un coffret d'un tableau électrique, selon la revendication 1.

Grâce à l'invention, il est possible de lier mécaniquement un rail à la paroi de montage d'un coffret, directement à travers la face antérieure de la paroi et sans la nécessité de tourner les parties en cours d'assemblage pour accéder à la partie postérieure.

Selon des aspects avantageux mais non obligatoires de l'invention, un tel dispositif de connexion peut incorporer une ou plusieurs des caractéristiques suivantes, prises selon toute combinaison techniquement admissible :
- le corps isolant comporte un trou borgne qui s'étend à partir d'une première surface antérieure de la portion de tête à l'intérieur du corps isolant le long de l'axe de référence, le trou borgne étant adapté pour recevoir une vis de fixation du rail au dispositif ;
- les moyens de couplage comportent une portion centrale, qui s'étend vers l'arrière de la partie de couplage, ainsi qu'un premier bras et un deuxième bras qui s'étendent à partir de la portion centrale transversalement par rapport à l'axe référence et selon des directions opposées entre elles ;
- les premier et deuxième bras sont configurés chacun en forme d'une pale d'hélice ;
- la portion de tête comporte au moins une autre surface d'appui pour une portion correspondante du rail.

En outre, le but susmentionné de la présente invention est également atteint par un tableau électrique comprenant un coffret, au moins un rail pour le montage d'équipements électriques, caractérisé en ce qu'il comporte au moins un dispositif tel que mentionné ci-dessus pour la connexion du rail à une paroi du coffret.

D'autres aspects et avantages de l'invention apparaîtront à la lecture de la description qui suit, donnée uniquement à titre d'exemple et faite en référence aux dessins annexés, parmi lesquels :
[FIG. 1] la Figure 1 est une vue illustrant le dispositif conforme à l'invention pour la connexion d'un rail métallique à une paroi de montage métallique d'un coffret d'un tableau électrique selon l'invention ;
[FIG. 2] la Figure 2 est une vue illustrant un rail métallique couplé à la paroi métallique postérieure d'un coffret d'un tableau en utilisant le dispositif illustré sur la figure 1, dans une première configuration de montage ;
[FIG. 3] la Figure 3 est une vue en section illustrant le dispositif illustré sur la figure 1, en position de connexion d'un rail métallique à la paroi métallique postérieure d'un coffret d'un tableau électrique dans une deuxième configuration de montage ;
[FIG. 4] la Figure 4 et une vue illustrant en détail une portion de fond du dispositif de la figure 1 avec des moyens de couplage qui sont déplacés en position d'appui contre la surface postérieure de la paroi métallique postérieure d'un coffret ; et
[FIG. 5] la Figure 5 et une vue illustrant un rail métallique en position de couplage mécanique à la paroi métallique postérieure d'un coffret d'un tableau électrique, en utilisant trois dispositifs selon l'invention.

Il est à noter que dans la description détaillée qui suit, les composants identiques ou similaires, du point de vue structurel et/ou fonctionnel, portent les mêmes références numériques, qu'ils soient représentés ou non dans des modes de réalisation différents de la présente description.

Il convient également de noter que, pour décrire de manière claire et concise la présente invention, les dessins ne sont pas nécessairement à l'échelle et que certaines caractéristiques peuvent être présentées sous une forme schématique.

En outre, lorsque le terme "adapté" ou "agencé" ou "configuré" est utilisé ici en se référant à tout composant dans son ensemble, ou à toute partie d'un composant, ou à une combinaison de composants, il doit être compris que cela signifie et englobe la structure et/ou la configuration et/ou la forme et/ou le positionnement du composant ou de la partie que ce terme désigne.

Enfin, lorsque les termes "substantiellement" ou "sensiblement" sont utilisés ici, ils doivent être compris comme englobant une possible variation de plus ou moins 5% par rapport à une valeur ou une position de référence indiquée ; de plus, lorsque les termes transversal ou transversalement sont utilisés ici, ils doivent être compris comme englobant une direction non parallèle à la ou aux pièces ou direction (s) / axe(s) de référence auxquel(le)s ils se réfèrent, et la perpendicularité doit être considérée comme un cas spécifique de direction transversale.

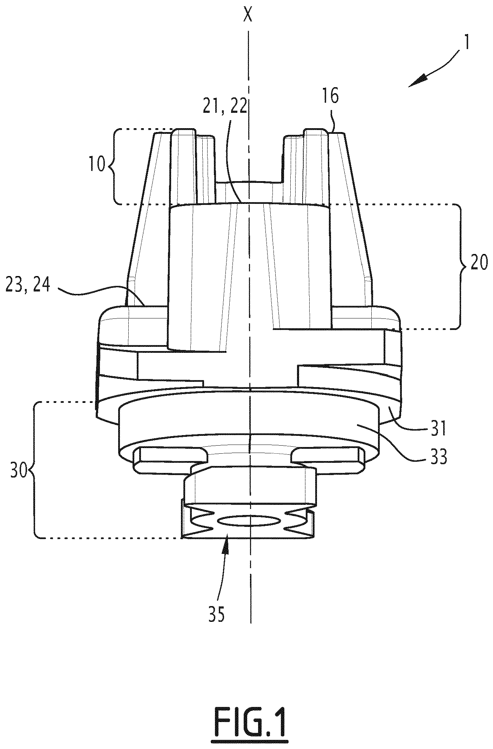

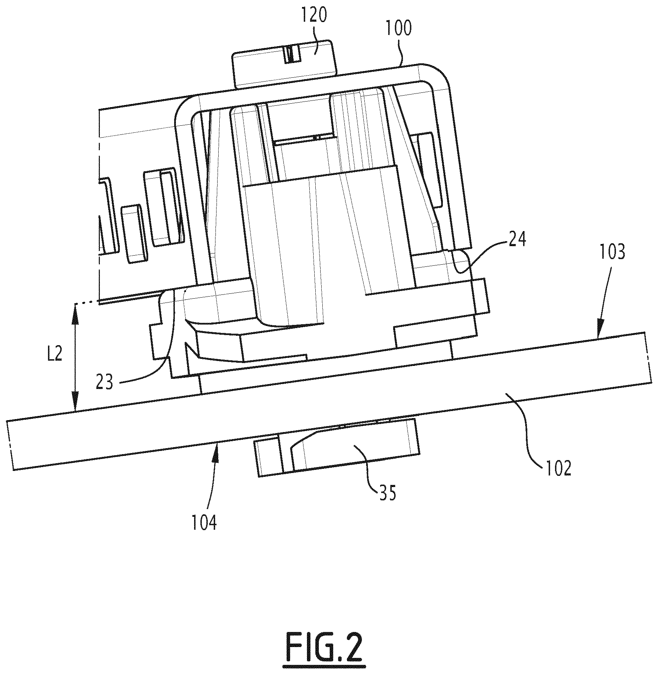

La figure 1 illustre un exemple de réalisation possible d'un dispositif selon la présente invention, désigné avec le numéro de référence 1, pour la connexion d'un rail métallique, désigné sur les figures 2, 3 et 5 par la référence 100, à une paroi de montage d'un coffret d'un tableau électrique.

Cette paroi de montage, désignée sur les figures 2 à 5 avec le numéro de référence 102, est typiquement une paroi postérieure d'un coffret, qui est réalisée en matériau métallique et comprend une surface antérieure 103 qui fait face à l'intérieur du coffret et une surface postérieure 104, opposée à la surface antérieure 103, qui fait face à l'extérieur du coffret.

Le dispositif 1 selon la présente invention comporte un corps réalisé en matériau électriquement isolant qui s'étend le long d'un axe de référence X transversal, et en particulier substantiellement perpendiculaire, par rapport à la paroi de montage 102 en configuration montée du dispositif 1 sur la paroi de montage 102.

Le dispositif 1 comporte une portion de tête 10, qui est configurée pour recevoir des moyens de fixation 120 du rail 100 au corps isolant du dispositif 1 lui-même, et une portion centrale 20 qui est configurée pour présenter au moins une première surface d'appui 21 pour une portion 106 associée du rail 100.

En outre, le corps isolant du dispositif 1 comporte une portion de fond 30, opposée à la portion de tête 10.

Comme illustré sur la figure 1, la portion centrale 20 s'étend, le long de l'axe de référence X, entre la portion de tête 10 et la portion de fond 30.

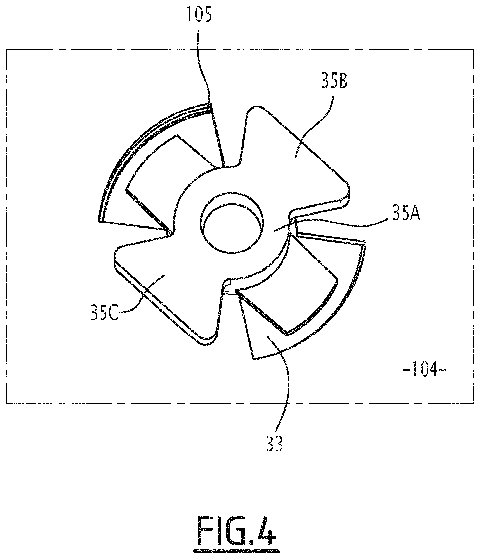

La portion de fond 30 comprend au moins :
- une surface d'appui 31 destinée à s'appuyer contre la surface antérieure 103 de la paroi de montage 102 ;
- une partie de couplage 33 qui s'étend vers l'arrière par rapport à la surface d'appui 31 et qui est adaptée pour être logée dans un siège traversant 105 illustré schématiquement sur la figure 4, qui est creusé dans la paroi de montage 102 ; et
- des moyens de couplage 35 qui s'étendent à partir de la partie de couplage 33 transversalement par rapport à l'axe de référence X.

Selon l'invention, le corps électriquement isolant du dispositif 1 est apte à être déplacé, pendant la connexion mécanique du rail 100 à la paroi de montage 102, entre une première position d'insertion, dans laquelle la surface d'appui 31 vient s'appuyer contre la surface antérieure 103 de la paroi de montage 102 tandis que la partie de couplage 33 est insérée dans le siège traversant 105 avec les moyens de couplage 35 qui passent au-delà du siège traversant 105, et une deuxième position d'appui, dans laquelle la partie de couplage 33 est tournée dans le siège 105, autour de l'axe de référence X, avec les moyens de couplage 35 qui font face à la surface postérieure 104 de la paroi de montage 102.

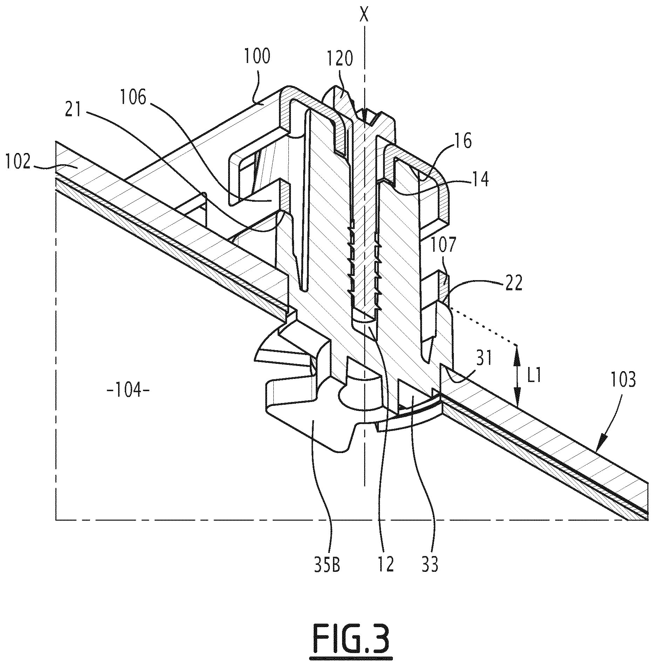

Selon une forme de réalisation possible, et comme visible plus en détail sur la figure 3, le corps électriquement isolant du dispositif 1 comporte un trou borgne 12 qui s'étend à partir d'une première surface antérieure 14 de la portion de tête 10 à l'intérieur du corps isolant le long de l'axe de référence X.

Comme illustré sur les figures 2, 3 et 5, les moyens de fixation 120 comportent une vis de fixation 120 qui est vissée dans le trou borgne 12 afin de lier mécaniquement le rail 100 au corps électriquement isolant du dispositif 1.

Selon une forme de réalisation possible, illustrée plus en détail sur la figure 4, les moyens de couplage 35 comportent une portion centrale 35A, ainsi qu'un premier bras 35B et un deuxième bras 35C qui s'étendent à partir de la portion centrale 35A transversalement, en particulier perpendiculairement, par rapport à l'axe référence X, et selon des directions opposées entre elles.

Selon l'exemple de réalisation illustré sur la figure 4, le premier bras 35B et le deuxième bras 35C sont configurés chacun en forme d'une pale d'hélice.

La portion centrale 20 du corps électriquement isolant comporte une première surface d'appui et une deuxième surface d'appui, identifiées sur la figure 3 par les références 21 et 22.

La première surface d'appui 21 et la deuxième surface d'appui 22 sont adaptées pour permettre l'appui de deux portions correspondantes 106 et 107 du rail 100 et sont disposées de manière substantiellement symétrique entre elles par rapport à l'axe de référence X.

Comme le montre la figure 3, en position de montage du dispositif 1, la première surface d'appui 21 et la deuxième surface d'appui 22 s'étendent selon des directions substantiellement parallèles à la paroi de montage 102 du coffret et sont situées, le long de la portion centrale 20, à une première distance L1 de la surface d'appui 31 de la portion de fond 30.

La portion centrale 20 du corps électriquement isolant comporte une troisième surface d'appui et une quatrième surface d'appui identifiées sur la figure 2 par les références correspondantes 23 et 24.

La troisième surface d'appui 23 et la quatrième surface d'appui 24 sont adaptées pour permettre l'appui de deux portions correspondantes du rail 100, telles que les portions 106 et 107 précédemment mentionnées ou deux autres portions différentes, et elles sont disposées de manière substantiellement symétrique entre elles par rapport à l'axe de référence X.

En particulier, comme visible sur la figure 2, en position de montage du dispositif 1, la troisième surface d'appui 23 et la quatrième surface d'appui 24 s'étendent selon des directions substantiellement parallèles à la paroi de montage 102 du coffret et sont situées, le long de la portion centrale 20, à une deuxième distance L2 de la surface d'appui 31 de la portion de fond 30.

La deuxième distance L2 est supérieure à la première distance L1.

De cette façon, grâce au dispositif 1 selon l'invention, le rail 100 peut être vissé au corps isolant et lié mécaniquement à la paroi de montage 102 dans une première position de support illustrée sur la figure 3, ou dans une deuxième position de support illustrée sur la figure 2 où il est placé plus loin de la paroi de montage par rapport à la première position de support.

Dans cette deuxième position de support, un espace plus grand est défini entre le rail 100 et la paroi de montage 102 permettant, par exemple, d'accueillir des composants de câblage, tels que des goulottes de câbles.

Selon une forme de réalisation possible, la portion de tête 10 du corps isolant comporte une deuxième surface antérieure 16, qui est située vers l'avant par rapport à la première surface antérieure 14 où l'ouverture du trous borgne 12 est formée, et qui constitue une autre surface d'appui pour une autre portion correspondante du rail 100.

En particulier, selon l'exemple de réalisation illustré sur la figure 3, la deuxième surface antérieure 16 comporte deux parties distantes entre elles d'un espace apte à permettre l'insertion de la vis 120.

Il ressort clairement de la description qui précède que le dispositif 1 permet d'atteindre le but à la base de la présente invention.

En effet, grâce au dispositif 1, il est possible de lier mécaniquement un rail à la paroi de montage d'un coffret, directement à travers la face antérieure de la paroi et sans la nécessité d'accéder à la partie postérieure par exemple en tournant les parties en cours d'assemblage.

En particulier, le verrouillage sur le fond du coffret peut être réalisé sans la nécessité d'utiliser des outils et des vis de fixation.

De cette façon, par rapport aux solutions connues, les procédures d'assemblage sont simplifiées et les temps de réalisation sont réduits, en assurent au même temps un dégrée de protection adéquat, notamment du type IP2 selon la norme EN 60529, en particulier pour ce qui concerne l'isolation électrique entre les parties internes du coffret et l'ambiance externe.

En outre, ces résultats sont obtenus avec une solution simple du point de vue constructif et très flexible à appliquer.

En effet, le dispositif 1 est adapté pour être appliqué en principe à tout type de coffret d'un tableau ou panneau électrique, notamment pour la distribution d'énergie en basse tension. En conséquence, la présente invention concerne également un tableau ou panneau électrique comprenant un coffret, au moins un rail 100 pour le montage d'équipements électriques et un dispositif 1 pour la connexion du rail 100 à une paroi 102 comme ci-dessus décrit.

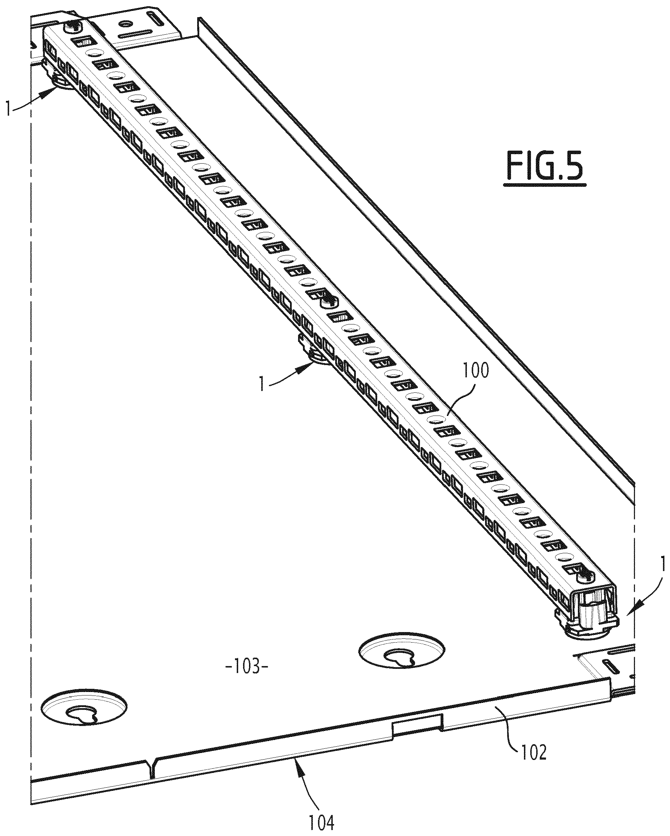

A cet égard, des rails de différentes longueurs peuvent être aisément liés à une paroi de montage, par exemple en utilisant seulement deux dispositifs 1 selon l'invention installés aux extrémités d'un rail, ou en ajoutant un troisième dispositif 1 dans une position intermédiaire, comme illustré par exemple sur la figure 5.

Le dispositif 1 ainsi conçu est susceptible de modifications et de variations. Par exemple, des parties du corps isolant, telles que les surface d'appui décrites peuvent être configuré de manière différente. En outre, les deux bras 35B et 35C peuvent être orientés de manière différente l'un par rapport à l'autre.

## Revendications

1. Dispositif (1) pour la connexion d'un rail métallique (100) à une paroi de montage métallique (102) d'un coffret d'un tableau électrique, comportant un corps réalisé en matériau électriquement isolant, le corps électriquement isolant s'étendent le long d'un axe de référence (X) transversal par rapport à la paroi de montage (102), en configuration montée du dispositif sur la paroi de montage, et comportant au moins :
- une portion de tête (10) configurée pour recevoir des moyens de fixation (120) du rail (100) au corps isolant du dispositif (1) ;
- une portion centrale (20) configurée pour présenter au moins une surface d'appui (21) adaptée pour permettre l'appui d'une portion correspondante (106) du rail (100) ;
- une portion de fond (30), opposée à la portion de tête (10), qui comporte au moins une surface d'appui (31) destinée à s'appuyer contre une surface antérieure (103) de la paroi de montage (102), une partie de couplage (33) qui s'étend vers l'arrière par rapport à la surface d'appui (31) et est adaptée pour être logée dans un siège traversant (105) creusé dans la paroi de montage (102), et des moyens de couplage (35) qui s'étendent à partir de la partie de couplage (33), dans lequel, pendant la connexion à la paroi de montage (102), le corps électriquement isolant du dispositif (1) est adapté à être déplacé entre une première position d'insertion dans laquelle la surface d'appui (31) est appuyée contre la surface antérieure (103) de la paroi de montage (102) tandis que la partie de couplage (33) est insérée dans le siège traversant (105) avec les moyens de couplage (35) qui passent au-delà du siège traversant (105), et une deuxième position d'appui dans laquelle la partie de couplage (33) est tournée dans le siège traversant (105) autour de l'axe de référence (X) avec les moyens de couplage (35) qui font face à la surface postérieure (104) de la paroi de montage (102) ;
dans lequel la portion centrale (20) comporte une première surface d'appui (21) et une deuxième surface d'appui (22) pour deux portions correspondantes (106, 107) du rail (100), les première et deuxième surfaces d'appui (21, 22) étant disposées de manière substantiellement symétrique entre elles par rapport à l'axe de référence (X), dans lequel, en configuration montée du dispositif sur la paroi de montage (102), la première surface d'appui (21) et la deuxième surface d'appui (22) s'étendent selon des directions substantiellement parallèles à la paroi de montage (102) et sont situées, le long de la portion centrale (20), à une première distance (L1) de la surface d'appui (31) de la portion de fond (30) ;
où la portion centrale (20) comporte en outre une troisième surface d'appui (23) et une quatrième surface d'appui (24) pour deux portions correspondantes du rail (100), les troisième et quatrième surfaces d'appui (23, 24) étant disposées de manière substantiellement symétrique entre elles par rapport à l'axe de référence (X), et où, en configuration montée du dispositif sur la paroi de montage (102), la troisième surface d'appui (23) et la quatrième surface d'appui (24) s'étendent selon des directions substantiellement parallèles à la paroi de montage (102) et sont situées, le long de la portion centrale (20), à une deuxième distance (L2) de la surface d'appui (31) de la portion de fond (30), la deuxième distance (L2) étant supérieure à la première distance (L1),
**caractérisé en ce que** le rail (100) peut être monté sur le corps isolant et lié mécaniquement à la paroi de montage (102) dans une première position de support, ou dans une deuxième position de support où il est placé plus loin de la paroi de montage (102) para rapport à la première position de support.

2. Dispositif (1) selon la revendication 1, dans lequel le corps isolant comporte un trou borgne (12) qui s'étend à partir d'une première surface antérieure (14) de la portion de tête (10) à l'intérieur du corps isolant le long de l'axe de référence (X), le trou borgne (12) étant adapté pour recevoir une vis de fixation (120) du rail (100) au dispositif (1).

3. Dispositif (1) selon l'une quelconque des revendications précédentes, dans lequel les moyens de couplage (35) comportent une portion centrale (35A), qui s'étend vers l'arrière de la partie de couplage (35), ainsi qu'un premier bras (35B) et un deuxième bras (35C) qui s'étendent à partir de la portion centrale (35A) transversalement par rapport à l'axe référence (X) et selon des directions opposées entre elles.

4. Dispositif (1) selon la revendication 3, dans lequel les premier et deuxième bras (35A, 35B) sont configurés chacun en forme d'une pale d'hélice.

5. Dispositif (1) selon la revendication 2, dans lequel la portion de tête (10) du corps électriquement isolant comporte une deuxième surface antérieure (16) ayant deux parties distantes entre elles d'un espace apte à permettre l'insertion de la vis de fixation (120).

6. Tableau électrique comprenant un coffret, au moins un rail (100) pour le montage d'équipements électriques, **caractérisé en ce qu'**il comporte au moins un dispositif (1) pour la connexion du rail (100) à une paroi (102) du coffret selon l'une quelconque des revendications précédentes.

## Patentansprüche

1. Vorrichtung (1) zum Verbinden einer Metallschiene (100) mit einer metallischen Montagewand (102) eines Kastens einer elektrischen Schalttafel, umfassend einen Körper, der aus elektrisch isolierendem Material hergestellt ist, wobei sich der elektrisch isolierende Körper in der montierten Konfiguration der Vorrichtung an der Montagewand entlang einer Bezugsachse (X) quer zu der Montagewand (102) erstreckt, und mindestens umfassend:
- einen Kopfabschnitt (10), der konfiguriert ist, um Befestigungseinrichtungen (120) der Schiene (100) an dem isolierenden Körper der Vorrichtung (1) aufzunehmen;
- einen mittleren Abschnitt (20), der konfiguriert ist, um mindestens eine Auflagefläche (21) aufzuweisen, die konfiguriert ist, um die Auflage eines entsprechenden Abschnitts (106) der Schiene (100) zu ermöglichen;
- einen Bodenabschnitt (30) gegenüber dem Kopfabschnitt (10), der mindestens eine Auflagefläche (31) umfasst, die dazu bestimmt ist, an einer vorderen Fläche (103) der Montagewand (102) anzuliegen, einen Kopplungsteil (33), der sich von der Auflagefläche (31) nach hinten erstreckt und angepasst ist, um in einem ausgehöhlten Durchgangssitz (105) in der Montagewand (102) untergebracht zu sein, und Kopplungseinrichtungen (35), die sich von dem Kopplungsteil (33) erstrecken, wobei der elektrisch isolierende Körper der Vorrichtung (1) während der Verbindung mit der Montagewand (102) angepasst ist, um zwischen einer ersten Einführungsposition, in der die Auflagefläche (31) an der vorderen Fläche (103) der Montagewand (102) anliegt, während der Kopplungsabschnitt (33) in den Durchgangssitz (105) eingeführt wird, wobei die Kopplungseinrichtungen (35) über den Durchgangssitz (105) hinausgehen, und einer zweiten Anlageposition, in der der Kopplungsabschnitt (33) in dem Durchgangssitz (105) um die Bezugsachse (X) gedreht wird, wobei die Kopplungseinrichtungen (35) der hinteren Oberfläche (104) der Montagewand (102) zugewandt sind, bewegt zu werden;
wobei der mittlere Abschnitt (20) eine erste Auflagefläche (21) und eine zweite Auflagefläche (22) für zwei entsprechende Abschnitte (106, 107) der Schiene (100) umfasst, wobei die erste und die zweite Auflagefläche (21, 22) im Wesentlichen symmetrisch zueinander in Bezug auf die Bezugsachse (X) angeordnet sind, wobei sich die erste Auflagefläche (21) und die zweite Auflagefläche (22) in der montierten Konfiguration der Vorrichtung an der Montagewand (102) in Richtungen im Wesentlichen parallel zu der Montagewand (102) erstrecken, und entlang des mittleren Abschnitts (20) in einem ersten Abstand (L1) von der Auflagefläche (31) des Bodenabschnitts (30) angeordnet sind;
wobei
der mittlere Abschnitt (20) ferner eine dritte Auflagefläche (23) und eine vierte Auflagefläche (24) für zwei entsprechende Abschnitte der Schiene (100) umfasst, die dritte und die vierte Auflagefläche (23, 24) in Bezug auf die Bezugsachse (X) im Wesentlichen symmetrisch zueinander angeordnet sind, und wobei
sich die dritte Auflagefläche (23) und die vierte Auflagefläche (24) in der an der Montagewand (102) montierten Konfiguration der Vorrichtung in Richtungen im Wesentlichen parallel zu der Montagewand (102) erstrecken, und sich entlang des mittleren Abschnitts (20) in einem zweiten Abstand (L2) von der Auflagefläche (31) des Bodenabschnitts (30) befinden, wobei der zweite Abstand (L2) größer ist als der erste Abstand (L1), **dadurch gekennzeichnet, dass** die Schiene (100) in einer ersten Halterungsposition oder in einer zweiten Halterungsposition, in der sie in Bezug auf die erste Halterungsposition weiter von der Montagewand (102) entfernt angeordnet ist, an dem Isolierkörper montiert und mechanisch mit der Montagewand (102) verbunden werden kann.

2. Vorrichtung (1) nach Anspruch 1, wobei der Isolierkörper ein Sackloch (12) aufweist, das sich von einer ersten vorderen Fläche (14) des Kopfabschnitts (10) innerhalb des Isolierkörpers entlang der Bezugsachse (X) erstreckt, wobei das Sackloch (12) angepasst ist, um eine Befestigungsschraube (120) der Schiene (100) an der Vorrichtung (1) aufzunehmen.

3. Vorrichtung (1) nach einem der vorherigen Ansprüche, wobei die Kopplungseinrichtungen (35) einen mittleren Abschnitt (35A), der sich von dem Kopplungsteil (35) nach hinten erstreckt, sowie einen ersten Arm (35B) und einen zweiten Arm (35C) umfassen, die sich von dem mittleren Abschnitt (35A) aus quer zu der Bezugsachse (X) und entlang einander entgegengesetzter Richtungen erstrecken.

4. Vorrichtung (1) nach Anspruch 3, wobei der erste und der zweite Arm (35A, 35B) jeweils in Form einer Propellerschaufel konfiguriert sind.

5. Vorrichtung (1) nach Anspruch 2, wobei der Kopfabschnitt (10) des elektrisch isolierenden Körpers eine zweite vordere Fläche (16) umfasst, die zwei Teile aufweist, die voneinander um einen Zwischenraum beabstandet sind, der geeignet ist, um das Einsetzen der Befestigungsschraube (120) zu ermöglichen.

6. Elektrische Schalttafel, umfassend einen Kasten, mindestens eine Schiene (100) zur Montage von elektrischen Geräten, **dadurch gekennzeichnet, dass** sie mindestens eine Vorrichtung (1) zur Verbindung der Schiene (100) mit einer Wand (102) des Kastens nach einem der vorherigen Ansprüche umfasst.

## Claims

1. A device (1) for connecting a metal rail (100) to a metal mounting wall (102) of an enclosure of an electrical switchboard, comprising a body made of electrically insulating material, the electrically insulating body extending along a reference axis (X) transverse to the mounting wall (102), in the configuration wherein the device is mounted on the mounting wall, and comprising at least:
- a head portion (10) configured to receive means (120) for attaching the rail (100) to the insulating body of the device (1);
- a central portion (20) configured to have at least one bearing surface (21) adapted to allow a corresponding portion (106) of the rail (100) to bear against it;
- a bottom portion (30), opposite the head portion (10), which comprises at least one bearing surface (31) for bearing against a front surface (103) of the mounting wall (102), a coupling part (33) which extends rearwardly with respect to the bearing surface (31) and is adapted to be accommodated in a pass-through seat (105) recessed in the mounting wall (102), and coupling means (35) which extend from the coupling portion (33), in which, whilst connecting to the mounting wall (102), the electrically insulating body of the device (1) is adapted to be moved between a first insertion position wherein the bearing surface (31) is pressed against the front surface (103) of the mounting wall (102) while the coupling part (33) is inserted into the pass-through seat (105) with the coupling means (35) going past the pass-through seat (105), and a second bearing position wherein the coupling portion (33) is rotated within the pass-through seat (105) about the reference axis (X) with the coupling means (35) facing the rear surface (104) of the mounting wall (102);
in which the central portion (20) comprises a first bearing surface (21) and a second bearing surface (22) for two corresponding portions (106, 107) of the rail (100), the first and second bearing surfaces (21, 22) being arranged substantially symmetrically with respect to the reference axis (X), in which, in the configuration wherein the device is mounted on the mounting wall, the first bearing surface (21) and the second bearing surface (22) extend in directions substantially parallel to the mounting wall (102) and are located, along the central portion (20), at a first distance (L1) from the bearing surface (31) of the bottom portion (30);
wherein
the central portion (20) further comprises a third bearing surface (23) and a fourth bearing surface (24) for two corresponding portions of the rail (100), the third and fourth bearing surfaces (23, 24) being arranged substantially symmetrically with respect to the reference axis (X), and wherein,
in the configuration wherein the device is mounted on the mounting wall (102), the third bearing surface (23) and the fourth bearing surface (24) extend in directions substantially parallel to the mounting wall (102) and are located, along the central portion (20), at a second distance (L2) from the bearing surface (31) of the bottom portion (30), the second distance (L2) being greater than the first distance (L1), **characterised in that** the rail (100) can be mounted on the insulating body and mechanically connected to the mounting wall (102) in a first support position, or in a second support position where it is placed further away from the mounting wall (102) with respect to the first support position.

2. The device (1) according to claim 1, in which the insulating body comprises a blind hole (12) which extends from a first front surface (14) of the head portion (10) inside the insulating body along the reference axis (X), the blind hole (12) being adapted to receive a screw (120) for attaching the rail (100) to the device (1).

3. The device (1) according to any of the preceding claims, in which the coupling means (35) comprise a central portion (35A), which extends towards the rear of the coupling part (35), as well as a first arm (35B) and a second arm (35C) which extend from the central portion (35A) transversely with respect to the reference axis (X) and in mutually opposite directions.

4. The device (1) according to claim 3, in which the first and second arms (35A, 35B) are each configured in the shape of a propeller blade.

5. The device (1) according to claim 2, in which the head portion (10) of the electrically insulating body comprises a second front surface (16) having two parts spaced apart by a gap suitable for allowing the fixing screw (120) to be inserted.

6. An electrical switchboard comprising an enclosure and at least one rail (100) for mounting electrical equipment, **characterised in that** it comprises at least one device (1) for connecting the rail (100) to a wall (102) of the enclosure according to any one of the preceding claims.
